(19) **Europäisches Patentamt**
**European Patent Office**
**Office européen des brevets**

(11) Publication number: **0 488 530 B1**

## EUROPEAN PATENT SPECIFICATION

(45) Date of publication of patent specification: **27.09.95**

(51) Int. Cl.⁶: **C09D 11/00**, G03F 7/14, G03F 7/022

(21) Application number: **91310015.2**

(22) Date of filing: **30.10.91**

(54) **Ink composition and process for producing a lithographic printing plate using the same.**

(30) Priority: **31.10.90 JP 296516/90**

(43) Date of publication of application:
**03.06.92 Bulletin 92/23**

(45) Publication of the grant of the patent:
**27.09.95 Bulletin 95/39**

(84) Designated Contracting States:
**DE FR GB IT**

(56) References cited:
**GB-A- 2 070 049**

**DATABASE WPIL, no. 82-64 839, DERWENT PUBLICATIONS LTD., London, GB; & JP-A-57 102 972**

**DATABASE WPIL, no. 87-046 848; DERWENT PUBLICATIONS LTD., London, GB; & JP-A-62 004 763**

(73) Proprietor: **Nippon Paint Co., Ltd.**
**1-2, Oyodo-kita 2-chome, Kita-ku**
**Osaka-shi**
**Osaka-fu (JP)**

(72) Inventor: **Hase, Takakazu**
**7-9, Kitashowa-cho**
**Nishinomiya-shi,**
**Hyogo-ken (JP)**
Inventor: **Arimatsu, Seiji**
**1-45-6, Kuzuhanoda**
**Hirakata-shi,Osaka-fu (JP)**
Inventor: **Kimoto, Koichi**
**1-12-10, Higashikori**
**Hirakata-shi,Osaka-fu (JP)**

(74) Representative: **Perry, Robert Edward et al**
**GILL JENNINGS & EVERY**
**Broadgate House**
**7 Eldon Street**
**London EC2M 7LH (GB)**

**Description**

FIELD OF THE INVENTION

The present invention relates to an ink composition and a process for producing a lithographic printing plate using the same. More particularly, the present invention relates to a direct platemaking system for offset printing wherein lithographic printing plates are prepared directly by ink-jet printing from digital information in a computer or a facsimile machine without using a positive film, and an aqueous ink composition therefor.

BACKGROUND OF THE INVENTION

Offset printing using lithographic printing plates is used in various printing areas, such as newspaper printing, commercial printing and the like, because print quality is superior to other printing processes. Most of the lithographic printing plates for offset printing are photosensitized plates (PS plates) having a photosensitive layer on a substrate and are classified into two types. One is a negative type wherein a portion exposed to light is cured, and the other is a positive type wherein a portion exposed to light is developed or eluted. The positive type one is mainly used for high quality color printing of for example posters, because the printing qualities are better than the negative type one.

On the other hand, computer technique has been remarkably developed in these days and a direct platemaking system has been proposed in which lithographic printing plates are made directly from the digital information output from computers or facsimile machines without using a positive or negative film.

In the direct platemaking system, a laser platemaking is known to the art. The laser platemaking is a scanning exposure process wherein a laser light is scanned on a photosensitive plate, such as a wipe-on plate, a PS plate and an electrophotographic plate, according to the digital information to form a printing plate without a positive or negative film. The photosensitive plate to be exposed to laser light does not have sufficient sensitivity and therefore the laser light has to have a high output power, so as to make the system cost-up. Also, the system needs complicated optical means for conducting the laser light, and driving means for scanning the whole surface of the photosensitive plate, so that the apparatus is made large.

An ink-jet platemaking is also known to the art. For example, Japanese Kokai Publication 56-113456 discloses a process wherein a photocurable silicone oil is printed by ink-jet printing to form a non-image area. Japanese Kokai Publication 64-27953 discloses a process wherein a hydrophobic material, which is solid at room temperature and melts at an elevated temperature, is printed by an ink-jet process using a thermal head on the plate to form an image area. Also, Japanese Kokai Publication 51-84303 discloses four processes wherein a silicone is printed by an ink-jet process, or wherein a catalyst for curing the silicone is printed on the silicone layer, or wherein a photopolymerizable ink recepter which can be bound with the silicone is printed thereon, or wherein light absorbing liquid is printed on the photocurable silicone layer. In the former two processes, the printed portion is a non-image portion and in the latter two processes, the printed portion is an image portion.

The process of Japanese Kokai Publication 56-113456 is not good from the economic viewpoint, because a large amount of silicone oil is printed as the non-image portion which is larger than the image portion. The resolution is also poor because printed portion by silicone oil is a non-image portion. In the process of Japanese Kokai Publication 64-27953, the hydrophobic ink material should be liquid at an elevated temperature whose viscosity is low enough to be used for ink-jet printing, and, as the result, solidified image area at room temperature is not strong enough to make many copies in printing. Also in the process of Japanese Kokai Publication 51-84303, the plate material to be printed and the ink to form image area should be specific and therefore the process is not good for practical use.

GB-A-2070049 discloses an ink composition comprising a water-soluble acid or direct dye, polyethylene glycol and a surface-active agent. The surface tension of the composition is 0.04 to 0.06 N/m.

SUMMARY OF THE INVENTION

An aqueous ink composition according to the present invention has a surface tension of 0.03 to 0.035 N/m, and comprises:

(a) 1 to 20 % of a dye having an absorption wavelength within 200 to 800 nm;
(b) 5 to 40 % of an evaporation-controlling agent; and
(c) 0.1 to 5 % of a surfactant having an HLB value of 12 to 14; the percentages being by weight based on the total weight of the composition.

This composition can be used to produce a lithographic printing plate by a process which comprises:

(i) printing an aqueous ink composition according to any preceding claim on a positive-type photosensitive plate by ink-jet printing; and

(ii) exposing the printed plate to light, followed by developing.

The resultant plate has excellent printing durability for ink-jet printing.

DETAILED DESCRIPTION OF THE INVENTION

The aqueous ink composition of the present invention functions as a mask film on the photosensitive plate and therefore should absorb light having a wavelength in the range to which the positive-type photosensitive plate will be photosensitive. The dye (a) therefore has such an absorption wavelength. Preferred dyes (a) are water-soluble or water-dispersible and the light absorption should be high enough to provide a pattern on the photosensitive plate, e.g. an average light absorbence of 500 nm. For example, when the photosensitive plate is prepared from naphthoquinonediazide and a novolac resin so as to have a photosensitive wave length range of 350 to 430 nm and exposed to a metal halide lamp, preferred dyes are Cathieon Black BXH (C.I. Acid Black 119), Sunchromine Black ET conc. (C.I. Mordant Black 11), Direct Black BH, Sumilight Supra Yellow 2GL (C.I. Direct Yellow 39), Kayacyl Yellow GG (C.I. Acid Yellow 17), Procion Brill Yellow 5-HG (C.I. Reactive Yellow 2), a mixture thereof and the like.

The evaporation controlling agent (b) of the present invention inhibits the evaporation of the solvents (e.g. water) of the ink composition to prevent nozzle plugging. Examples of the evaporation controlling agents are polyhydric alcohols, such as dihydric alcohols (e.g. ethylene glycol, diethylene glycol, triethylene glycol, tetraethylene glycol, propylene glycol, dipropylene glycol and polyethylene glycol), trihydric alcohols (e.g. glycerol and trimethylolpropane); a mixture thereof; and the like.

The surfactant (c) of the present invention controls a surface tension of the ink composition in order to prevent repelling and spreading of the ink composition on the photosensitive plate. It also prevents the photosensitive layer on the plate from dissolving with the ink composition. The surfactant (c) is not limited as long as the surface tension of the ink composition is adjusted to 30 to 35 dyn/cm, preferably 31 to 34 dyn/cm, and can be anionic, cationic or nonionic. If the ink-jet printing is conducted by a continuous jetting type, the surfactant (c) is preferably nonionic because the ink is electrostatically charged at the nozzle tip and changes direction in an electric field. The surfactant has an HLB value of 12 to 14. Typical examples of the surfactants (c) are a polyethyleneglycol alkylphenyl ether, such as polyethyleneglycol nonylphenyl ether and polyethyleneglycol lauryl ether; an aliphatic acid diethanol amide; a sodium alkylnaphthalene sulfonate; polyethyleneglycol nonylphenyl ether sulfate; polyethyleneglycol lauryl ether sulfuric acid triethanol amine; a phosphoric acid ester of polyethyleneglycol alkyl ether or polyethyleneglycol alkyl phenyl ether; a mixture thereof; and the like.

The aqueous medium of the ink composition is mainly deionized water. An organic solvent, such as alcohols may added thereto.

The aqueous ink composition of the present invention may contain other components, such as a buffering agent, a solubilizing agent, a defoaming agent, a bactericide, a stainproofing agent, a mildewcide and the like.

In the aqueous ink composition, the dye (a) is present in an amount of 1 to 20 % by weight, preferably 3 to 10 % by weight, based on the total amount of the composition. Amounts of more than 20 % by weight may generate agglomerates and the like. The evaporation controlling agent (b) is present in an amount of 5 to 40 % by weight, preferably 10 to 20 % by weight based on the total composition weight. If the agent is more than 40 % by weight, the ink composition may dissolve the photosensitive layer of the plate. The surfactant (c) is present in an amount of 0.1 to 5 % by weight, preferably 0.5 to 3 % by weight, based on the total composition weight. Amounts of more than 5 % by weight do not provide the technical effects of it in proportion to the amount.

The ink composition may be prepared by mixing the above mentioned components. The composition is required to have a surface tension of 30 to 35 dyn/cm. If it is less than 30 dyn/cm, repelling may occur. If it is more than 35 dyn/cm, spreading may occur.

In the process of the present invention, the ink composition obtained above is printed on the positive type photosensitive plate by way of ink-jet printing. The positive type photosensitive plate can be anyone which is commercially available. For example, the plate may be prepared by coating a photosensitive resin composition comprising naphthoquinonediazide and a novolac resin on a substrate. Examples of the substrates are paper, plastics, aluminum and the like. These photosensitive plates are commercially available for commercial printing and newspaper printing and have sufficient sensitivity, resolution and printing durability.

The ink-jet printing is a process wherein an ink is dropwise transferred onto the positive type photosensitive plate in accordance to electric signal of information pattern to be printed. The ink-jet printing is disclosed in US Patents 3,465,350, 3,465,351, 3,805,273, 3,832,579, 3,673,601, 3,683,212, 3,582,954, 3,060,429, 3,747,120, UK Patent 1,042,308 and the like. An ink-jet printing apparatus is also commercially available, for example Ink-jet Printer HG-800 available from Seiko Epson Co., Ltd and the like.

The printed photosensitive plate is then exposed to light. The light sources emit light having a emission wave length within the photosensitive wave range of the photosensitive plate. Typical examples of the light sources are a metal halide lamp, a high pressure mercury lamp and the like.

After exposing to light, the plate is developed to remove the exposed portion with a developer. The developed plate may be subjected to general treatments, such as finishing and the like, to obtain a lithographic printing plate.

In the process of the present invention, the images are printed out by ink-jet printing. Thus, printing is rapidly conducted and the apparatus can be made compact because complicated light systems are not needed. Platemaking cost is therefore reduced and its maintenance becomes easy.

The ink composition of the present invention makes it possible to directly conduct platemaking from digital information output from computers or facsimiles without a positive film.

In the process of the present invention, the conventional positive type photosensitive plates are usable and therefore good sensitivity and resolution are expected. Also, the resulting printing plates also have excellent printing durability.

The ink composition of the present invention does not have problems of repelling and spreading when printed and therefore printing qualities are good.

BRIEF EXPLANATIONS OF THE DRAWINGS

Fig.1 is a graph showing relations between the surface tension of the ink composition and the quality of the printed images.

Fig.2 is a graph showing the change of the remaining ink amount when an amount of the evaporation controlling agent (i.e. ethylene glycol) is changed. No. 1, 2, 3 and 4 represent Examples 25-27 and Comparative Example 11, respectively.

EXAMPLES

The present invention is illustrated by the following examples which, however, are not to be construed as limiting the present invention to their details.

Examples 1 to 15

The dyes listed in Table 1 was employed and an aqueous ink composition was prepared from the following ingredients.

| Ingredients | Parts by weight |
|---|---|
| Glycerol | 20.0 |
| Deionized water | 80.0 |
| Polyethyleneglycol nonyl phenyl ether | 2.0 |
| Dye listed in Table 1 | 2.0 |
| Total | 104.0 |

The obtained ink composition was charged in an ink-jet printer available from Seiko Epson Co., Ltd. as Ink-jet Printer HG-800, and printed on a positive type photosensitive plate available from Nippon Seihaku Co., Ltd. as Esper1. It was then exposed to a metal halide lamp having an output of 3 KW, and developed with a developer. The image quality of the obtained printing plate was evaluated and the result is shown in Table 1.

4

Example 16 and Comparative Example 1

An ink was prepared as generally described in Example 1, with the exception that the dye was not formulated (Comparative Example 1) or 5 parts by weight of the dye (Kayacyl Yellow GG) was employed. The same printing test was conducted and the result is also shown in Table 1.

Table 1

| Example number | Dye name | Amount (parts) | Printed image quality[1] | |
|---|---|---|---|---|
| | | | 50 mJ/cm | 100 mJ/cm |
| 1 | Sumilight Supra Yellow 2GL | 2 | 4 | 2 |
| 2 | Sunchromine Black ET conc. | 2 | 4 | 1 |
| 3 | Sumilan Black WA | 2 | 3 | 1 |
| 4 | Direct Black BH | 2 | 5 | 1 |
| 5 | Japanol Fast Black D conc. | 2 | - | - |
| 6 | Sumiacryl Black G | 2 | - | - |
| 7 | Procion Brill Yellow H-5G | 2 | 5 | 1 |
| 8 | Sumiacryl Black AP | 2 | 3 | 1 |
| 9 | Nigrosine | 2 | 2 | 1 |
| 10 | Cathieon Black BXH | 2 | 4 | 1 |
| 11 | Opal Black new conc. | 2 | - | - |
| 12 | Opal Black GNH | 2 | 1 | 1 |
| 13 | Cathilon Black ABH | 2 | - | - |
| 14 | Malachite Green | 2 | 4 | 2 |
| 15 | Kayacyl Yellow GG | 2 | 4 | 4 |
| 16 | Kayacyl Yellow GG | 5 | 5 | 5 |
| Comp. Ex. 1 | Nothing | 0 | 0 | 0 |

[1] Evaluation of printed images; 0 shows nothing remaining. 1 shows almost disappearing. 2 shows quite thin. 3 shows slightly thin. 4 shows good or slight thin. 5 shows good.

Examples 17 to 24 and Comparative Example 2 to 9

The surfactant listed in Table 2 was employed and an aqueous ink composition was prepared from the following ingredients and the surface tension is also shown in Table 2.

| Ingredients | Parts by weight |
|---|---|
| Glycerol | 20.0 |
| Deionized water | 80.0 |
| Surfactant listed in Table 2 | 2.0 |
| Kayacyl Yellow GG | 2.0 |
| Total | 104.0 |

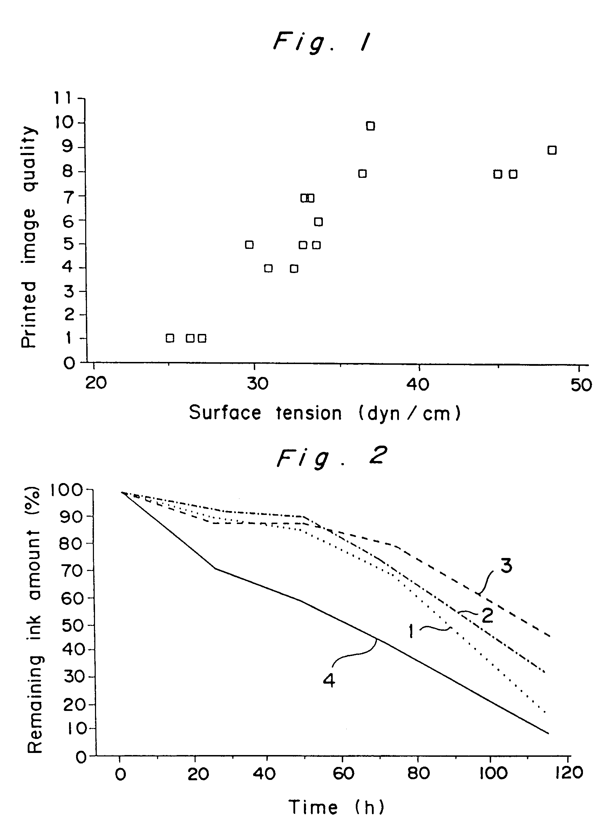

The obtained ink composition was printed and developed as generally described in Example 1 and the image quality of the obtained printing plate was evaluated and the result is shown in Table 2. The relation of surface tension and printed image quality is also shown in Fig.1. As is apparent from Fig.1, the ink compositions within the claimed surface tension range have good properties in repelling and spreading and also provide excellent image quality.

Comparative Example 10

An ink was prepared as generally described in Example 1, with the exception that an aqueous ink for ink-jet printing, which had the surface tension as shown in Table 2, was employed. The same printing test was conducted and the result is also shown in Table 2.

6

Table 2

| Example number | Surfactant | Surface tension[1] dyn/cm | Printed image quality[2] |
|---|---|---|---|
| 17 | Polyethyleneglycol lauryl ether (ET 143) HLB=14 | 30.8 | 4 |
| 18 | Polyethyleneglycol lauryl ether (Emulgen 109P) HLB=13 | 33 | 5 |
| 19 | Aliphatic acid diethanolamide (Dianol 300) | 30.1 | 5 |
| 20 | Sodium alkylnaphthalenesulfonate (Pelex NBL) | 33.8 | 5 |
| 21 | Polyethyleneglycol nonyl phenyl ether sulfate (Newcol 560SN) | 32.4 | 4 |
| 22 | Polyethyleneglycol lauryl ether, sulfuring triethanolamine (Sundit ET) | 34 | 6 |
| 23 | Polyethyleneglycol alkyl ether phosphate (GAFAC LO-529) | 33.1 | 7 |
| 24 | Polyethyleneglycol lauryl phenyl ether (EA120) HLB=12 | 33.5 | 7 |
| Comp. Ex. | | | |
| 2 | Polyethyleneglycol lauryl ether (ET83) HLB=8 | 24.7 | 1 |
| 3 | Polyethyleneglycol alkyl phenyl ether (Emuldit 16) HLB=18 | 48.4 | 9 |
| 4 | N-polyethyleneglycolalkylalkylamine (Amiradine D) | 46 | 8 |
| 5 | Sodium dialkylsulfosuccinate (Pelex OTP) | 26 | 1 |
| 6 | Sodium dialkylsulfosuccinate (Pelex TR) | 26.7 | 1 |
| 7 | Sodium polyethyleneglycol alkyl phenyl ether phosphate (Revenol WZ) | 45.1 | 8 |
| 8 | Sodium laurylsulfate (Emul O) | 37.2 | 10 |
| 9 | Polyethyleneglycol alkyl ether phosphate (GAFAC RD-720) | 36.7 | 8 |
| 10 | Aqueous ink for ink-jet printers (commercially available) | 61.4 | 9 |

[1] Surface tension was determined by Dynometer (platinum ring method, pulling out rate = 1.5 mm/min).

[2] Printed image quality is shown as 10 levels. The smaller the number, the worse the repelling. The larger the number, the worse the spreading. The 4-7 levels are acceptable.

Examples 25 to 27 and Comparative Example 11 The ethylene glycol of the amount listed in Table 1 was employed as the evaporation controlling agent and an aqueous ink composition was prepared from the following ingredients.

| Ingredients | Parts by weight |
|---|---|
| Ethylene glycol | X |
| Deionized water | 80.0 |
| Polyethyleneglycol nonyl phenyl ether | 2.0 |
| Kayacyl Yellow GG | 2.0 |
| Total | 84.0 + X |

The drying characteristics of the ink composition were evaluated by changing the amount of ethylene glycol and the result is shown in Table 3 and Fig. 2. The drying characteristics were determined by the change of weight of the ink composition. As is apparent from the result, the ink composition with an evaporation controlling agent has good drying characteristics.

Table 3

| | | | Examples | | | Comp. Ex. |
|---|---|---|---|---|---|---|
| | | | 25 | 26 | 27 | 11 |
| Amount of ethylene glycol (parts by weight) | | | 5 | 10 | 20 | 0 |
| Ink weight with time | 0 | | 100 | 100 | 100 | 100 |
| | 26 hours | | 90 | 93 | 88 | 71 |
| | 50 hours | | 85 | 90 | 88 | 58 |
| | 74 hours | | 68 | 71 | 79 | 41 |
| | 115 hours | | 14 | 30 | 45 | 7 |

**Claims**

1. An aqueous ink composition having a surface tension of 0.03 to 0.035 N/m, comprising:
   (a) 1 to 20 % of a dye having an absorption wavelength within 200 to 800 nm;
   (b) 5 to 40 % of an evaporation-controlling agent; and
   (c) 0.1 to 5 % of a surfactant having an HLB value of 12 to 14; the percentages being by weight based on the total weight of the composition.

2. A composition according to claim 1, wherein the dye is water-soluble or water-dispersible and has an average light absorbence of about 500 nm.

3. A composition according to claim 1 or claim 2, wherein the dye is selected from C.I. Acid Black 119, C.I. Mordant Black II, C.I. Direct Yellow 39, C.I. Acid Yellow 17, C.I. Reactive Yellow 2 and mixtures thereof.

4. A composition according to any preceding claim, wherein the evaporation-controlling agent comprises a polyhydric alcohol.

5. A composition according to any preceding claim, which comprises 3 to 10 % by weight of the dye.

6. A composition according to any preceding claim, which comprises 10 to 20 % by weight of the evaporation-controlling agent.

7. A process for producing a lithograpic printing plate, which comprises:

(i) printing an aqueous ink composition according to any preceding claim on a positive-type photosensitive plate by ink-jet printing; and

(ii) exposing the printed plate to light, followed by developing.

8. A process according to claim 7, wherein the plate is as prepared by coating a photosensitive composition comprising naphthoquinonediazide and a novolac resin on a substrate.

9. A process according to claim 8, wherein the plate is photosensitive at a wavelength of 350 to 430 nm when exposed to a metal halide lamp.

10. A process according to claim 9, wherein the aqueous ink composition comprises a dye as defined in claim 3.

**Patentansprüche**

1. Wäßrige Tinten-Zusammensetzung mit einer Oberflächenspannung von 0,03 bis 0,035 N/m, umfassend:

   (a) 1 bis 20 % eines Farbstoffs mit einer Absorptionswellenlänge innerhalb von 200 bis 800 nm;

   (b) 5 bis 40 % eines verdampfungskontrollierenden Mittels und

   (c) 0,1 bis 5 % eines Tensids mit einem HLB-Wert von 12 bis 14, wobei die Prozentangaben als Gewichtsprozente auf das Gesamtgewicht der Zusammensetzung bezogen sind.

2. Zusammensetzung gemäß Anspruch 1, in der der Farbstoff wasserlöslich oder wasserdispergierbar ist und eine mittlere Lichtabsorption von etwa 500 nm hat.

3. Zusammensetzung gemäß Anspruch 1 oder Anspruch 2, in der der Farbstoff ausgewählt wird aus C.I. Säureschwarz 119, C.I. Mordantschwarz II, C.I. Direktgelb 39, C.I. Säuregelb 17, C.I. Reaktivgelb 2 und deren Mischungen.

4. Zusammensetzung gemäß einem der vorhergehenden Ansprüche, in der das verdampfungskontrollierende Mittel einen mehrwertigen Alkohol umfaßt.

5. Zusammensetzung gemäß einem der vorhergehenden Ansprüche, die 3 bis 10 Gew.-% des Farbstoffs umfaßt.

6. Zusammensetzung gemäß einem der vorhergehenden Ansprüche, die 10 bis 20 Gew.-% des verdampfungskontrollierenden Mittels umfaßt.

7. Verfahren zur Herstellung einer lithographischen Druckplatte, umfassend:

   (i) Bedruckung einer lichtempfindlichen Platte vom Positiv-Typ mit einer wäßrigen Tinten-Zusammensetzung gemäß einem der vorhergehenden Ansprüche mittels Tintenstrahldruck; und

   (ii) Belichtung der bedruckten Platte, gefolgt von Entwicklung.

8. Verfahren gemäß Anspruch 7, bei dem die Platte durch Beschichtung eines Trägers mit einer lichtempfindlichen Zusammensetzung, umfassend Naphthochinondiazid und ein Novolak-Harz hergestellt ist.

9. Verfahren gemäß Anspruch 8, bei dem die Platte bei Belichtung mit einer Metallhalogenid-Lampe bei einer Wellenlänge von 350 bis 430 nm lichtempfindlich ist.

10. Verfahren gemäß Anspruch 9, wobei die wäßrige Tinten-Zusammensetzung einen Farbstoff gemäß Anspruch 3 umfaßt.

**Revendications**

1. Composition aqueuse d'encre ayant une tension superficielle de 0,03 à 0,035 N/m, comprenant :

   (a) 1 à 20 % d'un colorant ayant une longueur d'onde d'absorption de 200 à 800 nm ;

   (b) 5 à 40 % d'un agent de contrôle de l'évaporation ; et

(c) 0,1 à 5 % d'un tensioactif ayant une valeur HLB de 12 à 14, les pourcentages étant en poids, basés sur le poids total de la composition.

**2.** Composition selon la revendication 1, dans laquelle le colorant est soluble ou dispersible dans l'eau et présente une absorbance moyenne de lumière d'environ 500 nm.

**3.** Composition selon la revendication 1 ou 2, dans laquelle le colorant est choisi parmi C.I. Acid Black 119, C.I. Mordant Black II, C.I. Direct Yellow 39, C.I. Acid Yellow 17, C.I. Reactive Yellow 2 et leurs mélanges.

**4.** Composition selon l'une quelconque des revendications précédentes, dans laquelle l'agent de contrôle de l'évaporation comprend un polyalcool.

**5.** Composition selon l'une quelconque des revendications précédentes, qui comprend de 3 à 10 % en poids du colorant.

**6.** Composition selon l'une quelconque des revendications précédentes, qui comprend de 10 à 20 % en poids de l'agent de contrôle de l'évaporation.

**7.** Procédé de production d'une plaque d'impression lithographique, qui comprend les étapes consistant à :

i) imprimer une composition aqueuse d'encre selon l'une quelconque des revendications précédentes sur une plaque photosensible de type positif, par impression au jet d'encre ; et

(ii) exposer la plaque imprimée à la lumière, puis à la développer.

**8.** Procédé selon la revendication 7, dans lequel la plaque est préparée par revêtement d'un substrat par une composition photosensible comprenant du naphtoquinonediazide et une résine novolaque.

**9.** Procédé selon la revendication 8, dans lequel la plaque est photosensible pour une longueur d'onde de 350 à 430 nm lorsqu'elle est exposée à une lampe à halogénure métallique.

**10.** Procédé selon la revendication 9, dans lequel la composition aqueuse d'encre comprend un colorant tel que défini dans la revendication 3.

## Fig. 1

## Fig. 2